Europäisches Patentamt

European Patent Office

Office européen des brevets

(11) Publication number: **0 163 384**
**B1**

(12) EUROPEAN PATENT SPECIFICATION

(45) Date of publication of patent specification: 21.03.90

(21) Application number: 85302251.5

(22) Date of filing: 01.04.85

(51) Int. Cl.⁵: **H 01 L 27/02,** H 01 L 23/52 //
G11C11/24

(54) Power source lines arrangement in an integrated circuit.

(30) Priority: 30.03.84 JP 62926/84

(43) Date of publication of application:
04.12.85 Bulletin 85/49

(45) Publication of the grant of the patent:
21.03.90 Bulletin 90/12

(84) Designated Contracting States:
DE FR GB NL

(56) References cited:
EP-A-0 043 244
EP-A-0 103 362
WO-A-81/00171
FR-A-2 493 045
GB-A-2 087 183

PATENT ABSTRACTS OF JAPAN, vol. 7, no. 247
(E-208)1392r, 2nd November 1983 & JP-A-58-134
464

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Horiguchi, Fumio**
**3-26-3, Itabashi**
**Itabashi-ku Tokyo (JP)**

(74) Representative: **Freed, Arthur Woolf et al**
**MARKS & CLERK 57-60 Lincoln's Inn Fields**
**London WC2A 3LS (GB)**

Courier Press, Leamington Spa, England.

## Description

This invention relates to a semiconductor integrated circuit, and more particularly to a connection construction of the power source line in the integrated circuit.

Description of the Prior Art

Ordinarily, a semiconductor integrated circuit includes a multiplicity of semiconductor active elements and two power source lines for supplying electricity to these semiconductor elements, one being a power source voltage line and the other being a ground line.

In the power source lines of a conventional integrated circuit, noises are frequently introduced not only from outside but also created therein as a result of abrupt switching operation of the integrated circuit, thus disturbing the operation of the integrated circuit.

Furthermore, in case of a dynamic RAM of a large memory capacity such as 256 K bit RAM and a 1 M bit RAM, the power source lines become long, and steep current pulses created at the time of refreshing operation in the integrated circuit inevitably cause voltage drops in the long power source lines, thereby rendering the operation of the circuit to be unstable.

EP—A—0 043 244 discloses a static RAM having a power supply line above and parallel to a ground line with a dielectric between the lines.

An object of the present invention is to provide a semiconductor integrated circuit wherein the above described difficulties of the conventional circuits can be substantially eliminated.

Another object of the invention is to provide a semiconductor integrated circuit wherein noise occurring in the power source lines can be absorbed effectively and the power source voltage applied to the semiconductor active elements in the circuit can be maintained substantially stable regardless of abrupt change in the current flowing through the integrated circuit.

According to the present invention there is provided a semiconductor integrated circuit, comprising:

a semiconductor substrate; and

a power bus and a ground bus mounted on said substrate, for connection to an external power source (VCC); characterized by

a power source circuit mounted on said substrate, for regulating the voltage of the external power source (VCC) to be supplied to the power bus and the ground bus;

a memory cell array having bit lines mounted on said substrate; and

a precharge circuit (BL) mounted on said substrate, for precharging the bit lines of the memory cell array;

the power regulated bus supplying the voltage of the external power source as regulated by the power source circuit to the precharge circuit (BL), and;

in that said power regulated bus and said ground bus are disposed one over the other in a laminated manner along larger part of their length with a layer of a dielectric substance interposed therebetween so that said power regulated bus, said ground bus and said dielectric substance form a capacitance element.

With the above described connection construction of the power and ground buses, a capacitor of a predetermined capacitance is formed between a power bus and ground bus, and since the capacitor is provided adjacent to the semiconductor active elements, the capacitor absorbs the noises occurring in the buses effectively and supplies a heavy transient current which is required, for example, at the time of charging and discharging of the bit lines of a dynamic RAM. As a consequence, the amount of electric current to be supplied from outside and hence the variation of the power source voltage can be substantially reduced. In addition, erroneous operation of the integrated circuit caused by the variation of the power source voltage applied to the active elements of the circuit can be prevented, and a comparatively large operational margin can be allowed for the active elements, thus improving the yield in production of the active elements and reducing the production cost of the semiconductor integrated circuit.

Further, the laminated construction of the buses can improve the space factor and hence the degree of integration of the integrated circuit.

Ordinarily, when an electric current flows through a power bus, a magnetic field is created around the bus. The magnetic field defines a self-inductance of the power bus. In recent semiconductor integrated circuits such as dynamic RAM and the like where long power buses are required, the self-inductance causes a substantial amount of voltage drop in the power source lines. According to the present invention, since the power and ground buses are laminated in parallel and electric current flows through these buses oppositely, the magnetic field produced around the power and ground buses cancels with each other, and the self-inductance and hence the voltage drop can be reduced to minimum values.

Embodiments of the present invention will now be described with reference to the accompanying drawings in which:—

FIG. 1 is an equivalent circuit diagram showing one part of a semiconductor integrated circuit;

FIGS. 2 and 3 are equivalent circuit diagrams showing different applications of the integrated circuit shown in FIG. 1;

FIG. 4 is a sectional view showing one part of the integrated circuit shown in FIG. 2;

FIG. 5 is a circuit diagram showing one part of an ordinary dynamic RAM constituting an example of a semiconductor integrated circuit;

FIG. 6 is an equivalent circuit diagram showing the connection of power source lines in the dynamic RAM shown in FIG. 5, which constitutes embodiment of the invention;

FIG. 7 is a plan view showing important part of the embodiment shown in FIG. 6;

FIGS. 8(A) and 8(B) are sectional views taken along the lines A—A' and B—B' in FIG. 7;

FIG. 9 is a time chart for explaining a sensing operation of the embodiment shown in FIG. 6;

FIG. 10 is a diagram showing an allowable example of voltage drop caused in the power source of a semiconductor integrated circuit of this invention by a transient current flowing into the circuit; and

FIG. 11 is a sectional view showing schematically one example of the connecting portion of power source lines in a semiconductor integrated circuit of a multilayer construction, which constitutes still another embodiment of the invention.

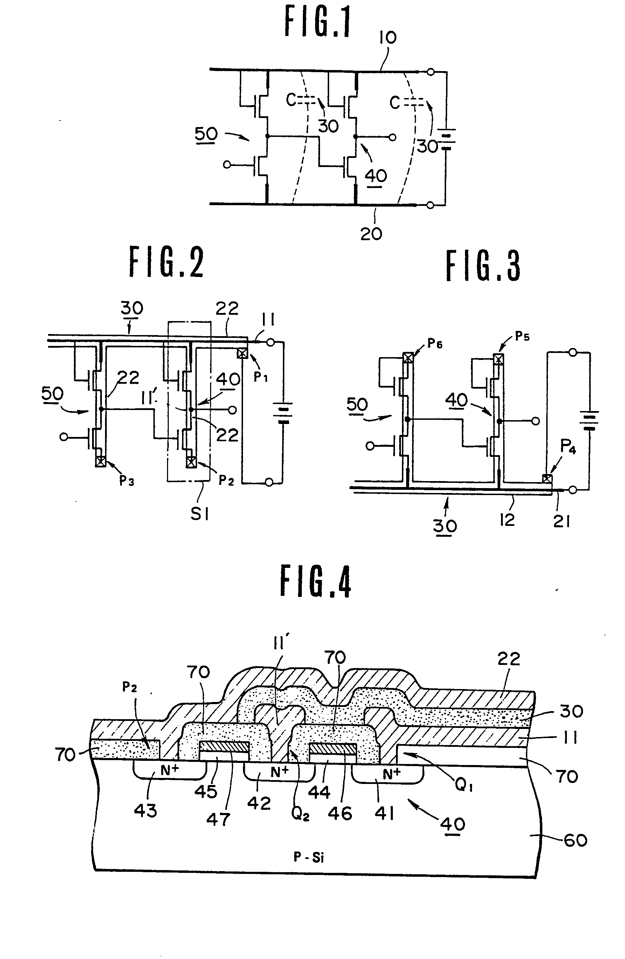

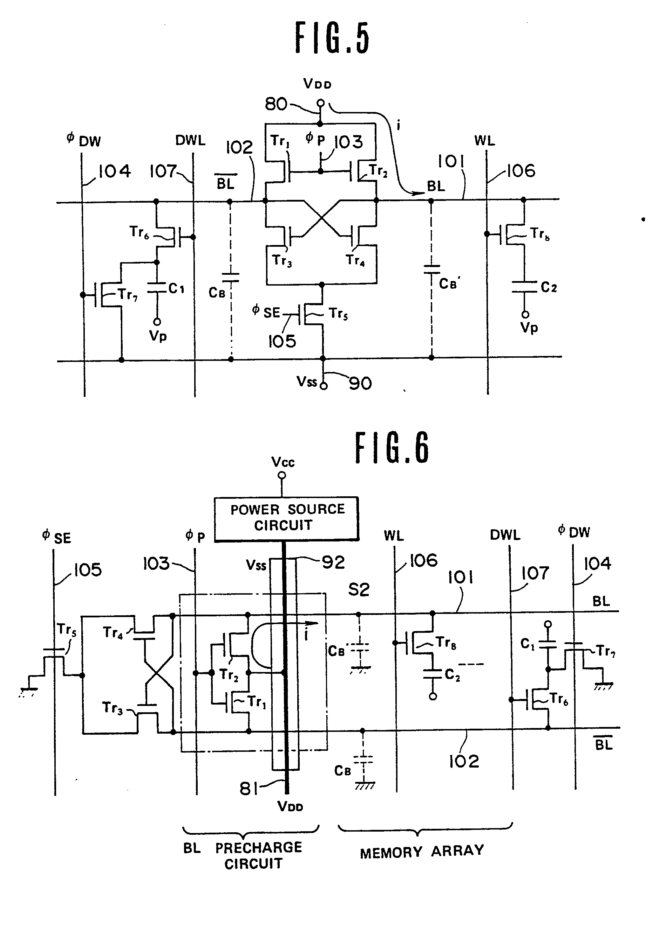

FIG. 1 illustrates an example of a semiconductor integrated circuit in the form of an inverter that comprises MOS FET pairs 40 and 50, a power source side wire 10 and an earth side wire 20 provided in the inverter are formed in lamination to be disposed in parallel with each other, and a suitable dielectric substance 30 is interposed between the wires 10 and 20 so as to form positively a capacitance C. The circuit may be executed in two different ways as shown in FIGS. 2 and 3. FIG. 2 illustrates one arrangement wherein the power source side wire is provided in a first layer (the wire in the first layer is designated by 11), while the earth side wire is provided in a second layer (the wire in the second layer is designated by 22) with a dielectric substance 30 interposed therebetween. The connection between the earth side wire 22 in the second layer and the earth electrode of the power source and the source electrodes of the MOS FET pairs 40 and 50, which are held at earth potential, are carried out in three-dimensional manner through contact holes $P_1$, $P_2$ and $P_3$, respectively. FIG. 4 illustrates schematically a cross-sectional construction of the circuit shown in FIG. 2, particularly of a circuit portion indicated by S1 which is related to the MOS FET pair 40.

The connection construction shown in FIG. 4 will now be described in detail. MOS FET pair 40 comprises three $N^+$ diffusion layers 41, 42 and 43 formed in a semiconductor substrate (P—Si) 60 assumed to be of P type, gate forming insulating layers 44 and 45 deposited in channel forming regions between the $N^+$ diffusion layers 41, 42 and 43, and gate forming electrode layers 46 and 47 which are made of, for instance, polysilicone and deposited on the insulating layers 44 and 45, respectively. The upper surface of the above described construction is evenly coated by an insulating layer 70 made of, for instance, $SiO_2$. Then contact holes $Q_1$ and $Q_2$ are formed through the insulating layer 70 at positions overlying the $N^+$ diffusion layers 41 and 42. Conductive layers 11 and 11' made of, for instance, aluminum to constitute the first connection layer are selectively deposited through the contact holes $Q_1$ and $Q_2$ for connecting the layers 11 and 11' electrically with the $N^+$ diffusion layers 41 and 42, respectively. The connection layer 11 corresponds to the power source side connection layer, while the connection leader 11' corresponds to a junction portion between the MOS FET pair 40 (in FIG. 2) which is operable as an output terminal of an inverter circuit. A dielectric substance layer 30 made of, for instance, $SiO_2$ is further deposited over the connection layers 11 and 11', and a contact hole $P_2$ is provided through the layer 30 (the contact hole $P_2$ may otherwise be provided after the deposition of the insulating layer 70) at a position overlying $N^+$ diffusion layer 43 which is operable as a source electrode of the MOS FET pair 40 held in earth potential. Then an earth side connection layer 22 made of, for instance, aluminum and constituting the second layer is deposited entirely so that the layer 22 is electrically connected with the $N^+$ diffusion layer 43 through the hole $P_2$. It should be noted that the earth side connection layer 22 is laminated in parallel with the power source side connection layer 11 with the dielectric substance layer 30 interposed therebetween. Furthermore, the opposing surfaces of the power source side connection layer 11 and the earth side connection layer 22 are positively increased so as to provide a required capacitance between the two layers.

On the other hand, the circuit shown in FIG. 3 is constructed as follows. At the time of laminating power source wires 10 and 20, the earth side wire is formed into a first layer (earth side wire formed in the first layer is designated by 21), while the power source side wire is formed into a second layer (power source side wire formed into the second layer is designated by 12) with a dielectric substance 30 interposed between the first and second layers. The connection of the power source side wire 12 disposed in the second layer with the power source electrode and also with the drain electrodes of the MOS FET pairs 40 and 50, which are held at a power source potential, are carried out in a three-dimensional manner through contact holes $P_4$, $P_5$ and $P_6$. It is apparent that the above described connection construction can be realized in a similar manner as that described with reference to FIG. 4, and further description thereof is omitted for avoiding redundancy.

An application of the semiconductor integrated circuit in the form of a dynamic RAM will now be described.

FIG. 5 is a circuit diagram showing an ordinary construction of a sensing amplifier of the dynamic RAM. The amplifier circuit comprises MOS transistors $Tr_1$ through $Tr_4$ used for providing a flip-flop circuit, MOS transistors $Tr_5$ and $Tr_7$ of sensing use, a MOS transistor $Tr_6$ used for switching dummy cell, a MOS transistor $Tr_8$ used for switching memory cell, a storing capacitor $C_1$ for the dummy cell, a storing capacitor $C_2$ for the memory cell, and stray capacitances $C_B$ and $C_B'$. In the circuit shown in FIG. 5, a power source line 80 is held at a power source potential $V_{DD}$, another power source line 90 is held at a power source potential $V_{SS}$, bit lines 101 and 102 are held at opposite potentials BL and $\overline{BL}$, a dummy cell reset signal $\varphi_{Dw}$ is applied to a signal line 104, a sensing operation start signal $\varphi_{SE}$ is applied to a signal line 105, a memory cell switching signal WL is applied to a signal line 106, and a dummy cell switching signal DWL is applied to a signal line 107.

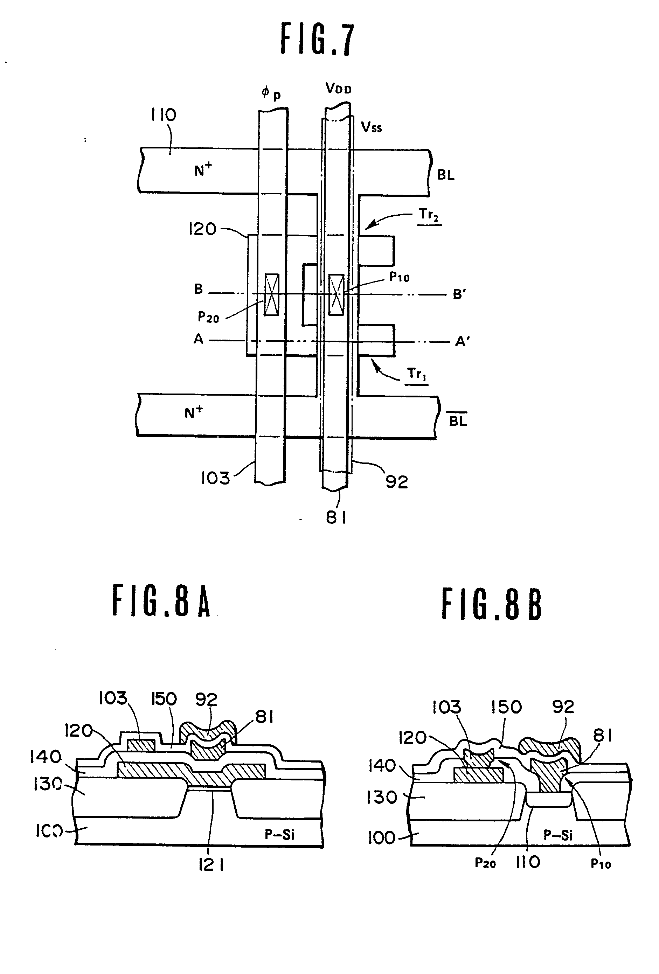

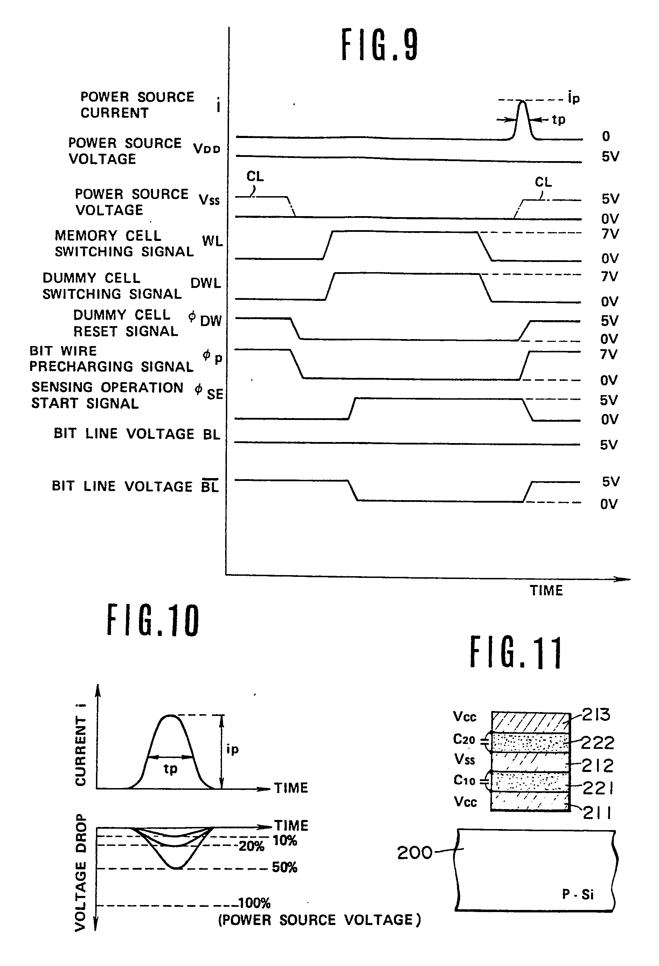

For the convenience of application of the present invention, the circuit shown in FIG. 5 is rearranged as shown in FIG. 6. In a practical dynamic RAM, the circuit shown in FIG. 6 is repeatedly arranged vertically along the lines 103, 104, 105, 106 and 107 into a required number of stages. In the shown embodiment, the power source lines 80 and 90 in FIG. 5 are formed into a laminated construction. It is assumed that the power source line at the potential $V_{DD}$ is disposed in the first layer (the line in the first layer is designated by 81), while the power source line at the potential $V_{SS}$ is arranged in the second layer (the line in the second layer is designated by 92). FIG. 7 is a plan view showing the laminated construction of the power source lines provided for a precharge circuit for the bit lines, which is surrounded by one dot dash line and indicated by $S_2$ in FIG. 6, and FIGS. 8(A) and 8(B) are sectional views taken along the lines A—A' and B—B' in FIG. 7.

The embodiment will now be described in detail with reference to FIGS. 6, 7, 8(A) and 8(B).

As is apparent in these drawings, each of the MOS transistors $Tr_1$ and $Tr_2$ is made of a P-type semiconductor substrate (P—Si) 100 in which a field oxide layer 130 is buried, a gate oxide layer 121 and a gate electrode layer 120 (see FIG. 8(A)) consisting of a polysilicon or else successively formed on the substrate 100, and an $N^+$ diffusion layer 110 (see FIGS. 7 and 8(B)) which is formed by ion-injecting an impurity such as As while utilizing the gate electrode layer 120 as a mask. In the shown embodiment, the entire surface is then covered by an insulating layer 140 of, for instance, $SiO_2$(CVD—$SiO_2$), and the power source line 81 in the form of a first layer made of a metal such as Al and to be held at the power source voltage $V_{DD}$ and a signal line 103 to which a bit line precharging signal $\varphi_p$ is applied are selectively desposited over the insulating layer 140 (see FIGS. 7 and 8(A)). A layer 150 of a dielectric substance such as $SiO_2$ (CVD—$SiO_2$) is then formed over the entire surface, and the power source line 92 in the form of the second layer made of a metal such as Al and to be held at the power source voltage $V_{SS}$ is deposited on the dielectric substance layer 150 such that the power source line 92 extends in parallel with the power source line 81 provided in the form of the first layer. As is apparent in FIG. 8(B), the power source line 81 is electrically connected through a contact hole $P_{10}$ with the $N^+$ diffusion layer 110 serving as a junction point between the drain electrode and the source electrode of the transistors $Tr_1$ and $Tr_2$, while the signal line 103 is electrically connected through a contact hole $P_{20}$ with a junction point between the gate electrodes of the transistors $Tr_1$ and $Tr_2$. With the above described connection construction, a circuit equivalent to that shown in FIG. 6 is realized.

In consideration of electrical properties of the dynamic RAM, the length of the power source line 80 held at a potential $V_{DD}$ increases in accordance with the size of the dynamic RAM. In case of 1 M bit dynamic RAM, the length of the power source line 80 will be approximately 10 mm with a width of 2 microns. Assuming that the power source line is made of Al, the resistance of the line 81 is expressed to be

$$R = (I \cdot _p)/S = (1 \times 0.05)/2 \times 10^{-4} = 250 \text{ ohms}$$

In case where approximately 1024 bit lines of 1 M bit dynamic RAM are charged to a high voltage required for the sensing operation of the amplifier, assuming that the stray capacity of each bit line $C_B = C_B' = 500$ fF, the total sum of the stray capacitance becomes 0.5 nF. Thus for charging, under 5V and within 20 ns, the bit lines from a low voltage resulting from the sensing operation to a high voltage required for resuming the same operation, a charging current of 125 mA is required. When such a heavy current flows through the power source line 80, a voltage drop as described above occurs, thus reducing the power source voltage and elongating cycle time required for the charging operation. Such an adverse effect can be eliminated by a connection construction of the power source lines as shown in FIG. 6 wherein the power source lines 81 and 92 are laminated with each other so that a large capacitance of, for instance 5 pF which is 10 times larger than 500 fF obtained for each bit line, is formed between the power source lines 81 and 92. By charging the bit lines from the capacitance without effects of the voltage drop of the power source lines, a high speed and noiseless charging of the same can be realized.

FIG. 9 is a time chart showing conditions of various signals during the sense operation of the dynamic RAM. According to the embodiment, it is possible to increase forcibly the power source potential $V_{SS}$ as shown by one-dot-dash line CL in FIG. 9 in synchronism with a precharging signal $\varphi_p$ of the bit lines so that the electric charge in the capacitance between the power source lines 81 and 92 is effectively utilized for charging the bit lines. Such an operation can be realized by connecting the power source line 92 at a potential $V_{SS}$ with a suitable power source not shown for increasing the potential of the power source line 92 for a time synchronized with the precharging signal $\varphi_p$.

Assuming that a current flowing through the power source lines to the bit lines, or more generally to the semiconductor integrated circuit, is i, a peak value of the current is $i_p$, and a duration time of 1/2 peak value of the current is $t_p$, the following relation holds between a voltage drop $\Delta V$ transiently caused by the current $i_p$ and the capacitance C provided between the laminated power source lines

$$\Delta V = (i_p \times 3\ t_p)/C \qquad (1)$$

Thus, by selecting the voltage drop $\Delta V$ in a range allowable for realizing a stable operation of the semiconductor integrated circuit, the capacitance C for assuring stable operation of the integrated circuit is determined from the following relation

$$C \geqq (i_p \times t_p)/\Delta V \qquad (2)$$

That is, the required capacitance C is determined by firstly calculating the allowable voltage drop $\Delta V$, and then by substituting the value in equation (2). After the value of the capacitance C has been thus determined, the widths and lengths and the layout of the power source lines as well as the thickness of the dielectric substance and the material of the related elements may be determined in accordance with the semiconductor integrated circuit. Herein, the values of $i_p$ and $t_p$ in equation (2) can be determined comparatively easily from the specific feature of the semiconductor insulated circuit.

When it is assumed that the power source voltage is held at 5 (V), the allowable voltage drop $\Delta V$ is selected to be 1 (V) being 20% of the power source voltage, the peak value $i_p$ of the power source current is 125 (mA), and the duration time $t_p$ of the 1/2 peak value is 2 (ns), then the capacitance C is calculated as follows.

$$C = (iu_p \times t_p)/\Delta V = (125 \times 2)/1 = 0.25 \text{ (nF)}$$

This indicates that a stable operation of the integrated circuit can be assured for a capacitance C more than 0.25 nF.

For the realization of the aforementioned value of the capacitance C, the semiconductor integrated circuit may be designed such that the width and the length of the power source lines are 100 microns and 100 (mm), respectively, and a dielectric substance of $SiO_2$ is interposed between the power source layers at a thicknes of approximately 1.0 micron. In this manner, a capacitance C of 0.35 (nF) which is sufficiently larger than the above described value 0.25 (nF) can be obtained, and it is confirmed that the advantageous features of the present invention can be realized by the semiconductor integrated circuit of the above described design.

In case where the condition of the voltage drop becomes more strict and a value of 0.5 (V) corresponding to 10% of the power source voltage 5 (V) is selected to be the limiting value $\Delta V$, the required value of the capacitance C becomes

$$C = (125 \times 2)/0.5 = 0.5 \text{ (nF)}$$

and hence the design of the semiconductor integrated circuit is changed in accordance with the value of the capacitance C.

It should be noted that the condition related to the limiting value $\Delta V$ of the voltage drop is varied depending on the size and the kind of the semiconductor integrated circuit. Ordinarily, the limiting value $\Delta V$ of approximately 50% of the power source voltage is utilized for determining the required value of the capacitance C, and in case where the condition becomes more strict, a limiting value $\Delta V$ of 20% or 10% of the power source voltage is selected thereby determining the capacitance C.

FIG. 10 illustrates a relation between the power source current in and the limiting value of the voltage drop in various conditions.

Although in the above described construction, it has been assumed that the power source lines laminated in parallel are made of a metal such as aluminum, either one of the power source lines may otherwise be made of polysilicon or polycide which is used for the gate electrode of MOS transistors.

The dielectric substance disposed between the power source lines is not necessarily restricted to $SiO_2$ as described above, but many other substances having higher dielectric constants, such as nitrides and $Ta_2O_5$, may otherwise be used for increasing the capacitance while maintaining the thickness of the dielectric substance at a constant value.

The invention may otherwise be applied to a semiconductor integrated circuit of a multilayer connection construction. In a case where the construction has three layers, a connection layer 211 of a potential $V_{CC}$, a dielectric substance layer 221, another connection layer 212 of a potential $V_{SS}$, another dielectric substance layer 222, and still another connection layer 213 of a potential $V_{CC}$ are deposited in this order on a substrate 200 as schematically illustrated in FIG. 11. In the shown construction, a capacitance $C_{10}$ is formed between the connection layers 211 and 212, and another capacitance $C_{20}$ is formed between the connection layers 212 and 213. The multilayer integrated circuit of the above described construction can exhibit advantageous features similar to those of the embodiments described hereinbefore. Of course, the potentials of the connection layers in FIG. 11 may be reversed to each other, and it is apparent that the invention can be applied to multilayer integrated circuits having more than three layers.

**Claims**

1. A semiconductor integrated circuit, comprising:

   a semiconductor substrate (100); and
   a power bus (81) and a ground bus (92) mounted on said substrate, for connection to an external power source (VCC); characterized by
   a power source circuit mounted on said substrate (100), for regulating the voltage of the external power source (VCC) to be supplied to the power bus (81) and the ground bus (92);
   a memory cell array having bit lines (101, 102) mounted on said substrate; and
   a precharging circuit (BL) mounted on said substrate, for precharging the bit lines of the memory cell array;
   the power regulated bus supplying the voltage of the external power source as regulated by the power source circuit of the precharge circuit (BL), and

in that said power regulated bus (81) and said ground bus (92) are disposed one over the other in a laminated manner along larger part of their length with a layer of a dielectric substance (150) interposed therebetween so that said power regulated bus (81), said ground bus (92) and said dielectric substance (150) form a capacitance element.

2. A semiconductor integrated circuit according to claim 1, characterized in that said power regulated bus (81) and ground bus (92) are of aluminium.

3. A semiconductor integrated circuit according to claim 1, characterized in that said precharge circuit (BL) includes at least one active element, and one of said power regulated bus and ground bus is of alumium and the other of the power regulated bus and ground bus is of a material identical to said active element such as polysilicon or polycide.

4. A semiconductor integrated circuit according to claim 1, characterized in that said dielectric substance is $SiO_2$.

5. A semiconductor integrated circuit according to claim 1, characterized in that said dielectric substance is of a nitride or $Ta_2O_5$ having a high dielectric constant.

## Patentansprüche

1. Leiteranordnung für die Energieversorgung in einer integrierten Schaltung mit einem Halbleitersubstrat (100) sowie einer Leiteranordnung aus einem Leistungsbus (81) und einem geerdeten Grundbus (92), die auf dem Halbleitersubstrat aufgebracht sind und zur Verbindung damit einer externen Energiequelle (VCC) dienen, gekennzeichnet durch

eine auf das Halbleitersubstrat (100) aufgebrachte Leistungsschaltung für die Energiequelle zum Regeln der Spannung der externen Energiequelle (VCC), die dem Leistungsbus (81) und dem Grundbus (92) zuzuführen ist;

eine auf das Substrat (100) aufgebrachte Speicherzellenanordnung mit Bit-Leightungen (101, 102);

eine auf das Substrat (100) aufgebrachte Vorladeschaltung (BL) zum Vorladen der Bit-Teitungen der Speicherzellenanordnung, wobei der geregelte Leistungsbus die Spannung der externen Energiequelle durch die Leistungsschaltung geregelt der Vorladeschaltung zuführt,

und ferner dadurch gekennzeichnet, daß der geregelte Leistungsbus (81) und der Grundbus (92) über den größeren Teil ihrer Länge übereinandergesechichtet angeordnet sind, wobei eine Schicht eines Diekeltrikums (150) dazwischengelegen ist, so daß der geregelte Leistungsbus (81), der Grundbus (92) und das Dielektrikum (150) ein Kapazitätselement bilden.

2. Leiteranordnung nach Anspruch 1, dadurch gekennzeichnet, daß der geregelte Leistungsbus (81) und der Grundbus (92) aus Aluminium sind.

3. Leiteranordnung nach Anspruch 1, dadurch gekennzeichnet, daß die Vorladeschaltung (BL) zumindest ein aktives Element enhält, daß eine der Leiteranordnungen aus geregeltem Leistungsbus und Grundbus aus Aluminium ist, und daß die andere der Leiteranordnungen aus geregeltem Leistungsbus und Grundbus aus dem gleichen Material wie das aktive Element ist, z.B. aus Polysilizium oder Polycide.

4. Leiteranordnung nach Anspruch 1, dadurch gekennzeichnet, daß das Material des Dielektrikums $SiO_2$ ist.

5. Leiteranordnung nach Anspruch 1, dadurch gekennzeichnet, daß das Dielktrikum ein Nitrid oder $Ta_2O_5$ mit hoher Dielektrizitätskonstante ist.

## Revendications

1. Circuit intégré à semi-conducteur, comprenant: un substrat semi-conducteur (100), un bus (81) de puissance et un bus (92) de terre montés sur ledit substrat pour permettre une connexion à une source extérieure d'alimentation en puissance, caractérisé par un circuit d'alimentation en puissance monté sur ledit substrat (100), pour la régulation de la tension de la source extérieure d'alimentation (VCC) à être alimentée aux bus de puissance (81) et de terre (92); une rangée de cellules à mémoire ayant des lignes binaires (101, 102) montées sur ledit substrat; et un circuit de précharge (BL) monté sur ledit substrat, pour le préchargement des lignes binaires de la rangée de cellules à mémoire, le bus régulé de puissance alimentant la source extérieure d'alimentation en puissance, tel que régulé par le circuit d'almentation au circuit de précharge (BL), et en ce que ledit bus (81) régulé de puisance et ledit bus (92) de terre sont disposées l'un sur l'autre en couches sur la plus grande partie de leur longueur avec une couche d'une matière diélectrique (150) interposée entre eux, de telle sorte que ledit bus (81) de puissance, ledit bus (92) de terre et ladite substance diélectrique (150) forment un ensemble capacitif.

2. Circuit intégré selon la revendication 1, caractérisé en ce que ledit bus (81) régulé de puissance et ledit bus (92) de terre sont en aluminium.

3. Circuit intégré selon la revendication 1, caractérisé en ce que ledit circuit de précharge (BL) comporte au moins un élément actif, l'un desdits bus, régulé de puissance ou de terre, étant en aluminium alors que l'autre bus est de la même matière que l'élément actif, tel qu'un polysilicone ou un polycide.

4. Circuit intégré selon la revendication 1, caractérisé en ce que la substance diélectrique est du $SiO_2$.

5. Circuit intégré selon la revendication 1, caractérisé en ce que la substance diélectrique est un nitrure ou du $Ta_2O_5$ ayant une grande constante diélectrique.

# FIG.1

# FIG.2

# FIG.3

# FIG.4

# FIG.5

# FIG.6

BL PRECHARGE CIRCUIT

MEMORY ARRAY

# FIG.7

# FIG.8A

# FIG.8B

# FIG.9

POWER SOURCE CURRENT i

POWER SOURCE VOLTAGE $V_{DD}$

POWER SOURCE VOLTAGE $V_{SS}$

MEMORY CELL SWITCHING SIGNAL WL

DUMMY CELL SWITCHING SIGNAL DWL

DUMMY CELL RESET SIGNAL $\phi_{DW}$

BIT WIRE PRECHARGING SIGNAL $\phi_p$

SENSING OPERATION START SIGNAL $\phi_{SE}$

BIT LINE VOLTAGE BL

BIT LINE VOLTAGE $\overline{BL}$

$i_p$

$t_p$

CL     CL

0

5V

5V
0V

7V
0V

7V
0V

5V
0V

7V
0V

5V
0V

5V

5V
0V

TIME

# FIG.10

CURRENT i

$i_p$

$t_p$

TIME

VOLTAGE DROP

TIME
10%
20%
50%
100%
(POWER SOURCE VOLTAGE)

# FIG.11

$V_{cc}$ — 213
$C_{20}$ — 222
$V_{ss}$ — 212
$C_{10}$ — 221
$V_{cc}$ — 211

200 —

P · Si

4